# EUROPEAN PATENT APPLICATION

(11) **EP 0 548 032 A2**
(43) Date of publication of application: **23.06.1993**
(21) Application number: 92830665.3
(22) Date of filing: 10.12.1992
(51) Int. Cl.: H01J 37/32, C23C 14/32

(54) **Electric arc evaporator**

(30) Priority: 13.12.1991 IT BS910137
(71) Applicant: UNICOAT S.r.l., I-24060 Pianico, Bergamo (IT)
(72) Inventor: Belletti, Manuela, I-24060 Pianico, Bergamo (IT)
(74) Representative: Manzoni, Alessandro

(57) **Abstract**

The present invention relates to an electric arc evaporator including an anode (1), a support (2) for the part to be coated, a cathode group with a disc -shaped cathode to be evaporated (3), a current-carrier (4) and a main screen (5), that surrounds the periphery of the cathode (3). The height of the cathode (3) is inferior at least four times to its diameter, the current-carrier (4) is bucket-shaped and is in electrical contact with the non- evaporating surface of the cathode (3) and in that the cathode and the current-carrier are surrounded by an additional magnetic screen.

## Description

### Field of the technic

This invention belong to the field of the constitution of the coatings obtained high vacuum by condensation of the metallic plasma coming from the surface of an electrode in the presence of a voltage arc.

### State of the art

Many vaporizers for the constitution of the metallic high vacuum coatings are well-known. The heating and the evaporation of the metal that deposits as coating can be obtained in different ways: ohmic, inductive, by electronic beam, by voltaic arc vaporization.

Unlike the others, the last method allows to obtain highly ionized flows of the metallic plasma with a high density of the particles; and that gives many possibilities in the field of the coatings and allows to obtain a very high adhesion of the coatings to the base (comparable with the breakage-resistance of the same material), very hard coatings that contain high melting point alloys and that are composed like carbides, nitrides, oxides, etc., and a high productivity for what concerns the coated surface in the unit of time.

The metallic plasma deposited on the part which must be coated comes from the surface of the cathode only in that part of the cathode spot in which the voltaic arc is situated. The cathode spot follows a random path on the surface of the electrode to be evaporated. For a correct working of the vaporizer, the cathode spot must necessarily stay steady on the surface to be evaporated. The passage of the cathode spot on the lateral surface of the electrode to be evaporated can cause not only the distribution of that part of the cathode, but also the extinction of the arc.

There are some voltaic arc vaporizers in which different methods and systems are utilized to obtain the stability of the cathode spot on the working surface of the electrode to be evaporated.

These methods and systems are described in the patents USA 2972695, 4559121 and 4512867.

In the first one (US-2972695) is described a device that works as a screen insulated from the electrodes. This screen is situated on the cathode's lateral surface which is not subjected to evaporation, so that they are separated by a little interstice. In its random path, the cathode spot can come into contact with the lateral surface of the cathode, inside the screen, so that the metallic plasma flow, which functions as electric conductor between the cathode spot and the anode, stops and the cathode spot disappears.

To obtain the stabilization of the arc is better to have two cathode spots on the surface to be evaporated, and this would allow to increase the current of the voltaic arc till 140 A versus a value of 60 A that you usually have for example for the titanium and the zirconium with just one cathode spot. If one of the cathode spots goes under the screen, and so extinguishes itself, the other electric discharges comes to make another cathode spot. It has two parts, but keeps unchanged the number of the original cathode spots.

In the above-described device, the stabilization of the electric discharge is obtained by combining the elctrostatic screen with a certain value of the arc's current. If that current falls under this value, the stabilization doesn't take place. The probability of the arc's extinction is inversely proportional to the quantity of cathode spots on the cathode's evaporation surface. Nevertheless the increase of the arc's current causes a quantity of macroparticles to appear (drops phase) in the flow of the metallic plasma; these macroparticles damage the quality of the coating.

In the second patent above-mentioned (US-4559121), to limit the movement of the cathode spot on the surface of the cathode, is employed a ring that is in contact with the cathode that limits the passage of the cathode spot on the lateral surface. That ring is composed by a material, the secondary emission of which is inferior to the one of the other particles of the arc with an electric charge. On the other hand the surface energy of the material of the ring is inferior to the one of the material to be evaporated (for example, nitride of boron). Besides the material to be evaporated with its ring is contained in another ring with high magnetic permeability. The presence of those rings helps the atomization of the material to be evaporated. Nevertheless the electrio discharge passes also on the rings from which some material evaporates. This material, combined with the residual particles of the vacuum, contaminates the ionic flow.

In the third patent above-mentioned (US-4512867) are described a method and a device used to fix magnetcally the cathode spot on a particular part of the cathode's surface.

In this device the cathode is disc-shaped and, as anode, is used the high vacuum room. The parts to be coated are placed in front of the cathode on a special support, which is electrically insulated from the anode. The support is hollow to allow the refrigerant fluid to flow in the cathode. In fact the cathode is placed in a sleeve-shaped element, of a not-magnetic material, round which is wound an electromagnetic coil. It is placed in a way that the lines of force of its magnetic field are inclined towards the cathode's top surface. Along the external surface, the electro-magnetic coil is surrounded by a magnetic circuit and this strenghten the influence of the magnetic field on the movement of the cathode spot along the cathode's top. The coil's current can be regulated to obtain a uniform erosion of the cathode.

After the starting of the arc, under the influence of the coil's magnetic field, the cathode spot starts moving on the cathode's top with a circular trajectory and so the cathode spot is avoided to pass on the cathode's lateral surface. The current's intensity in the magnetic coil is modulated in such a way that the disposition of cathode's spot is uniform. In this way the stabilization of the arc is obtained. Such device can work with a very low arc's current, guaranting a high quality of the coating. Nevertheless it has the following disadvantages:
- low speed of coating (it is not possible to increase the output by increasing the arc's current, because increasing the current increases also the probability to have drops phase);
- general complexity;
- employement of extra electric power supply to generate the magnetic field.

### Invention Novelty

The aim of the invention is to reduce as much as you can the constitution of rough particles (drops phase) and to bring a qualitative improvement of the coatings, the structural semplification of the vaporizer and the reduction of its weight and its bulkiness, by using the magnetic field produced by the current which runs through the wire that conducts that current to the cathode and by lowering the temperature of the whole evaporation area (autostabilization of the discharge).

All this in a first phase of realization is obtained by a disc-shaped cathode having an height inferior to 1/4 of its diameter, having a peripheric groove and with a bucket-shaped current-carrier. The bucket is placed on the disc and connected with it through its edges. The delimitation cavity of the bucket is used to contain the refrigerant fluid. The assembly of cathode and current-carrier is surrounded by a screen.

The contact between cathode and current-carrier along the whole peripherical edge of the cathode allows a perfect distribution of the cathode spot so that the use of external magnetic fields is unnecessary.

Besides the temperature of the evaporation area of the cathode can be reduced thanks to the cooling caused by the refrigerant fluid and to the thin thickness of the disc that is part of the cathode. As a consequence, the probability for the drops phase to take place is reduced. During the process of evaporation and so of worning-out of the cathode, as a consequence of the bucket-shape of the current-carrier, a lifted edge constitutes on the cathode, along its periphery.

The lifted edge is useful to allow a symmetric disposition of the cathode and of the screen, mainly keeping the screen and the periphery of the cathode at the same level.

In another solution, to achieve the same aim, instead of the peripheric groove, the current-carrier has a diameter inferior to the one of the cathode and has a rim in contact with the top of the cathode along a circumference that is placed inside the cathode's peripherical surface. If the edge is not necessary, the current-carrier can surround the cathode's lateral surface and in that case the cathode can be without grooves. When the screen is connected with the anode through a resistor, the screen itself has the function of an additional anode. This allows to reduce considerably the current of the arc and to avoid the constitution of the drops phase. The current in the circuit of the additional anode appears only when the cathode spot goes from the top surface to the lateral one. In consequence of the bad conditions of the arc, which is between the lateral surfaces, the cathode spot comes back by itself on the cathode's top surface, and in such conditions the arc doesn't extinguish spontaneously.

The presence of the magnetic screen causes the conductors' external magnetic fields to influence negatively the magnetic field that defines the trajectory of the cathode spot.

To avoid the damage of the arc passing on the vaporizer's structure during the evaporation phase - especially for hardly evaporating materials - the cathode-holder screen and the magnetic screens are connected with the anode, each one of them through an electric condenser. If you connect the cathode-holder screen with the cathode through a resistor or leave it under the influence of a fluctuating potential, a double discharge of the arc - that destroys the vaporizer's part (cathode-screen, screen-anode) - can take place.

To vaporize easily melting and valuable metals, the cathode's disc is bucket-shaped with its cavity turned towards the support screen and full of material to be evaporated, The bucket is in high melting point metal and with its bottom surface cooled by the refrigerant fluid.

Other details of the invention will become more evident by reading the rest of the description, which is made referring to some examples of practical realization that are shown in the enclosed draw ings.

In these draw ings:
- figure 1 is a general schematic section of the vaporizer with one of the changes for the connection between the cathode and the current-carrier;
- figure 2 & 3 show two further changes for the connection between the cathode and the current-carrier;
- figure 4 shows a vaporizer with a hollow cathode;
- figure 5 & 6 show two different sections of the surface to be evaporated in regime conditions, considering the height-diameter ratio of the cathode.

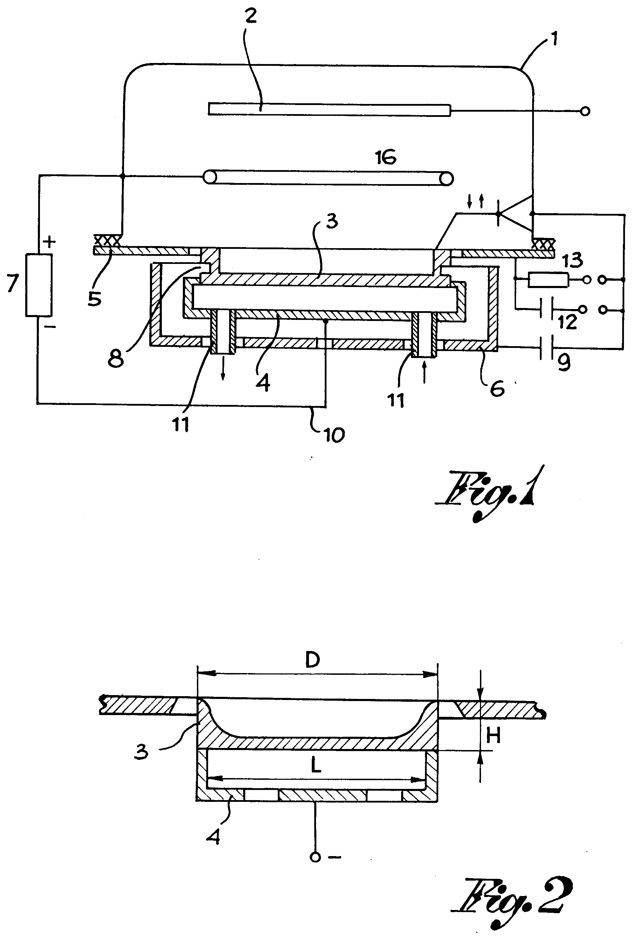

In the model illustrated in figure 1, the vaporizer is composed by an anode-room 1, a workrest 2, a cathode 3, a current-carrier 4, a main screen 5 that surrounds the lateral surface of the cathode 3, a power supply source 7 and an electrode of starting the cathode in front of the workrest 2.

The current-carrier 4, in inox steel, surrounds the cathode 3. In corrispondence of the points of contact between the current-carrier 4 and the cathode 3, it has a peripherical groove 8 which can be, for example, 3,5 mm deep.

Besides there is an additional magnetic screen 6 of high magnetic permeability, that is connected with the anode 1 through a condenser 9 and that surrounds the external part of the current-carrier 4. In the middle of the magnetic screen there is a hole through which the current-carrier 4 is separated from the bottom of the cathode 3, so that they create a cavity 4a. This cavity is runned through by the refrigerant fluid that flows through the joints 11.

The main screen 5 surrounds the surface of the cathode 3 and is connected with the anode-room 1 through the condenser 12. In case you want to obtain coatings of a particularly high quality, the current of discharge must be as low as possible. To limit such current, the main screen 5 is connected with the anode through a resistor 13.

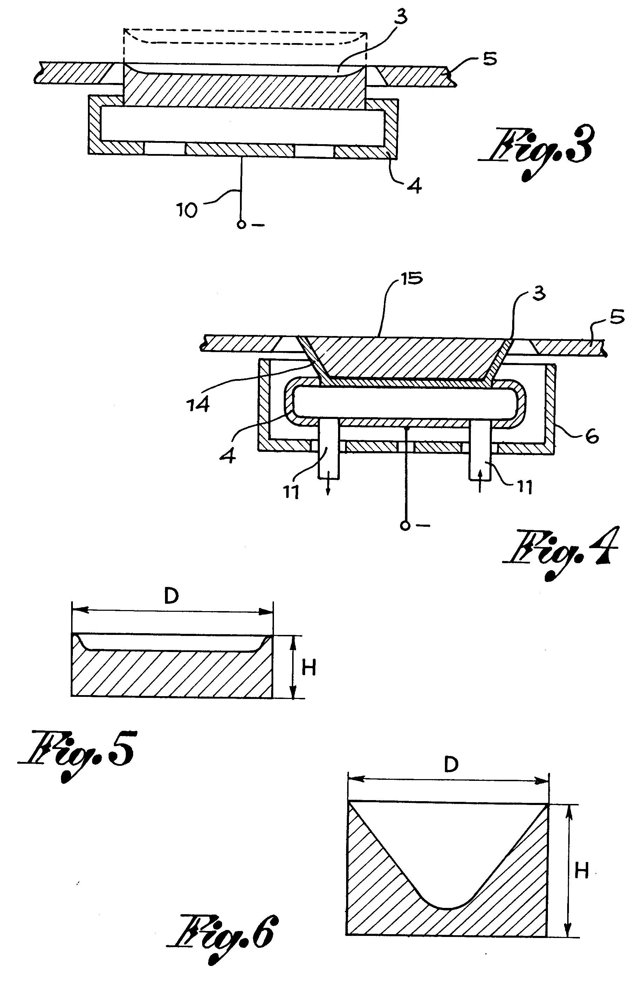

Figure 2 shows the case in which the current-carrier is connected with the cathode 3 under it instead of on its side. In this case, the inner diameter of the current carrier 4 is inferior to the diameter of the cathode D, and this allows the constitution of a lifted rim on the cathode, during the working.

Figure 3 shows the current-carrier 4 fixed to the electrode 3 on the external surface, but without the groove 8 shown in the figure 1. To reduce the flow of the evaporated metal on the lateral surfaces of the cathode 3, the edge of the internal hole of the main screen 5 is blunt as shown.

Figure 4 shows a vaporizer with a bucket-shaped cathode in which the metal to be evaporated 15 has been melted.

In the anode room 1 of figure 1, the pression decrease from an original value, for example, of 1.33 E -1 to a final value of 6,65 E -3 Pa. With the help of the power supply source 7, between the anode and the cathode a d.d.p. of about 60 V rises. The starting electrode 16 connected with the anode through a resistor (not rappresented) is brought to a direct contact with the cathode 3 and the electric discharge starts.

The refrigerant fluid of the cathode's sides flows through the pipes 11 in the cavity 4a of the current-carrier 4, and this allows its cooling. This cooling reduces drastically the probability for the drops phase to appear, and allows the stabilization of the cathode's evaporation. The cathode's cooling has the advantage that the bottom that remains till the worning-out of the cathode has a thin thickness, till some tenth of millimeter,

The autostabilization of the discharge is conditioned by the structural characteristics of the current-carrier, from the place in which the electrical contact with the cathode 3 takes place, the dimensions of which must have such a ratio to obtain a more effective cooling. The current of discharge, during the process of evaporation generates a magnetic field that allows the uniform distribution of the arc's cathode spot on the whole surface to be evaporated. As a consequence there is a uniform consumption of the cathode and a good plasmatic flow. This result with the usual vaporizers is obtained with an heavy and bulky electro-magnetic regulation.

It has been experimentally proved that the best cooling effect is obtained when the diameter D of the cathode is superior to its thickness or its height H. The diameter-height ratio can reach the value of 4. When this dimensional ratio is respected the upper surface of the cathode is flat, not sunken, and this increases the use of the cathode material and at the same time improves the stabilization of the consumption of the arc. It must be noticed that you have a constant discharge with a current of 60 - 70 A (values near the threshold for the titanium). Using the screen 5 as an additional anode, after having connected the anode 1 and the resistor 13, the current of discharge can be reduced till 45 - 50 A. With such values the speed of evaporation is low, nevertheless the quality of the plasmatic flow increases considerably, as the sprays decrease.

### Realization of the invention

The different ratio between the diameter D of the disc cathode and its thickness or height H leads to a different moulding of the surface to be evaporated (figg. 5 & 6). Reducing the ratio, the moulding takes a more 'cell-like' shape. This shape is acquired in function of the changing rate of the speed of coating-deposition on the sector of the support, that is usually at 250 mm from the surface to be evaporated in front of the middle of the cathode (a distance of 250 mm is in fact the best to obtain good quality coatings).

During the constitution of the "alveolus" (opening), while its moulding is being outlined, the speed of deposition on the sector of the support above-mentioned increases thanks to the focalizing action of the surface to be evaporated. In that case the directional diagrams of the flows show that the flows are directed mainly from the peripherical and central areas of the surface to be evaporated towards the above mentioned sector of the support. The focalizing effect of the "alveolus" from a qualitative point of view can show that the moulding, measuring the speed of deposition of the coating on the sector of the support at the beginning and after the process, has acquired peculiar outlines (the speed of evaporation has stopped to change). The change of speed of deposition decreases with the increase of the ratio between the diameter D and the height H of the cathode and becomes inferior to the 20%, Starting with a value of 4. It's possible a change of the speed of deposition of 20% and the lack of uniformity of the thickness of the coating that follows. For this reason value 4 can be considered the limit value from which the consumption of the cathode can be considered uniform. Figure 2 & 3 show mouldings of surfaces to be evaporated obtained experimentally using cathodes and current-carriers of different material. In case the cathode 3 and the current-carrier 4 are used as illustrated in the solution of figure 3, during the process, the cathode must be turned towards the part to be coated and in such a way that the surface to be evaporated can be at the same level of the screen 5. During the evaporation of the valuable metals the cathode 3 is made like a thin side bucket 14, to limit as much as possible the waste of material. This bucket is filled with metal to be evaporated 15. If the "bucket" 14 is made in high melting point metal, the material of the bucket will not evaporate during the discharge and will not contaminate the plasmatic flow. This vaporizer is useful also for the evaporation of easily melting metals (cadmium, zinc calcium. etc.).

As a proof a cathode group for vaporizers has been made following the scheme of fig.1. The disc-shaped cathode in titanium had the diameter of 80 mm. The thickness of the cathode has been changed and cathodes with a thickness of 40, 30, 20, 10, 5, 3 mm have been used. The arc has been started by the starting electrode connected with the anode through a resistor. The magnetic screen was made in inox steel of a thickness of 3 mm; the capacitance of the condensers was 20 µF. The current of discharge was 100 and 50 A. After the working, all the cathodes having a thickness of 40 and 30 mm had a cone-shaped "alveolus", which had changed the speed of deposition (more than 20%). From the thickness of 20 mm, and even less, the speed of deposition hasn't had any substantial changes (less than 20%), and moreover the thinner the cathode was, the less the speed of deposition during the evaporation changed. With the decrease of the thickness of the cathode, the proportion of the drops phase in the flow of the metallic vapour changed considerably. The proportion of the drops phase was reduced to a half. With the cathode of the thickness of 3 mm and with a current of discharge of 50 A, high quality coatings have been obtained, that can be also used in the optics field. So the disc-shaped cathode has been substituted by a bucket-shaped cathode, which is made in titanium and in which an easily melting metal had been poured (zinc, cadmium, calcium, sodium). The current of the arc was 20 and 10 A. The content of titanium in the condensate is not known. The obtained coating hadn't any drops phase. In that way, using the proposed cathode system, can be obtained not only coatings of a quality which is not different from the thermic coatings but also a series of advantages, among which the general simplicity, an immediate start of the evaporation after the connection with the energetic source, a high degree of ionization of the vapour, etc.

## Claims

1. Voltaic arc vaporizer including an anode (1), a support (2) for the part to be coated, a cathode group with a disc-shaped cathode to be evaporated (3), a current-carrier (4) and a main screen (5), that surrounds the lateral surface of the cathode (3) characterized in that the height of the cathode (3) is inferior at least four times to its diameter, in that the current-carrier (4) is bucket-shaped and is in electrical contact with the not evaporating surface of the cathode (3) and in that the cathode and the current-carrier are surrounded by an additional magnetic screen (6).

2. Voltaic arc vaporizer as claimed in claim 1), characterized in that the current-carrier is an element in which the cooling fluid of the cathode circulates.

3. Vaporizer as claimed in claim 1), characterized in that the current-carrier (4) is in electrical contact with the cathode (3) along its lateral surface, near the top opposite to the surface to be evaporated.

4. Vaporizer as claimed in claim 3), characterized in that along the lateral surface of the cathode (3), near the point of contact with the current-carrier (4), a circular groove is planned.

5. Vaporizer as claimed in claim 1), characterized in that the current-carrier (4) is in electrical contact with the cathode (3) along the top opposite to the surface to be evaporated.

6. Vaporizer as claimed in claim 1), characterized in that the screen (5) is connected with the anode through a condenser (12).

7. Vaporizer as claimed in claim 1), characterized in that the main screen (5) is connected with the anode through a resister (13).

8. Vaporizer as claimed in claim 1), characterized in that the additional magnetic screen (6) is connected with the anode through a condenser (9).

9. Vaporizer as claimed in claim 1), characterized in that the disc-cathode (3) is bucket-shaped (14); this bucket is made in high melting point material and is filled with material to be evaporated (15).
